# EUROPEAN PATENT SPECIFICATION

(11) **EP 2 324 517 B1**
(45) Date of publication and mention of the grant of the patent: **28.12.2011**
(21) Application number: 09784981.4
(22) Date of filing: 21.08.2009
(51) Int. Cl.: H01L 51/00

(54) **ORGANIC ELECTRONIC DEVICES AND METHODS OF MAKING THE SAME USING SOLUTION PROCESSING TECHNIQUES**
ORGANISCHE ELEKTRONISCHE ANORDNUNGEN UND VERFAHREN ZU IHRER HERSTELLUNG UNTER VERWENDUNG VON LÖSUNGSVERARBEITUNGSTECHNIKEN
DISPOSITIFS ÉLECTRONIQUES ORGANIQUES ET LEURS PROCÉDÉS DE FABRICATION UTILISANT DES TECHNIQUES DE TRAITEMENT DE SOLUTION

(30) Priority: 21.08.2008 GB 0815287
(43) Date of publication of application: 25.05.2011
(73) Proprietor: Cambridge Display Technology Limited, Business Park, Cambridgeshire B23 6DW (GB)
(72) Inventor: McCONNELL, Angela, Business Park Cambridgeshire (GB)
(74) Representative: Sharp, Alan Cooper
(86) International application number: PCT/GB2009/002044
(87) International publication number: WO 2010/020790

(56) References cited:
- WO-A-2007/023272
- US-A1- 2007 020 899

## Description

### Field of Invention

The present invention relates to organic electronic devices and methods of making the same using solution processing techniques. Particular embodiments of the present invention relate to organic thin film transistors, Organic optoelectronic devices, organic light emissive display devices and methods of making the same using solution processing techniques.

### Background of the Invention

Methods of manufacturing organic electronic devices involving depositing active organic components from solution are known in the art. Such methods involve the preparation of a substrate onto which one or more active organic components can be deposited. If active organic components are deposited from solution, one problem is how to contain the active organic components in desired areas of the substrate. One solution to this problem is to provide a substrate comprising a patterned bank layer defining wells in which the active organic components can be deposited in solution. The wells contain the solution while it is drying such that the active organic components remain in the areas of the substrate defined by the wells. An example of this method is described in US 2007/0020899.

The aforementioned solution processing methods have been found to be particularly useful for deposition of organic materials in solution. The organic materials may be conductive, semi-conductive, and/or opto-electrically active such that they can emit light when an electric current is passed through them or detect light by generating a current when light impinges on them. Devices which utilize these materials are known as organic electronic devices. An example is an organic transistor device. If the organic material is a light-emissive material the device is known as an organic light-emissive device. Transistors and light emissive devices are discussed in more detail below.

Transistors can be divided into two main types: bipolar junction transistors and field-effect transistors. Both types share a common structure comprising three electrodes with a semi-conductive material disposed therebetween in a channel region. The three electrodes of a bipolar junction transistor are known as the emitter, collector and base, whereas in a field-effect transistor the three electrodes are known as the source, drain and gate. Bipolar junction transistors may be described as current-operated devices as the current between the emitter and collector is controlled by the current flowing between the base and emitter. In contrast, field-effect transistors may be described as voltage-operated devices as the current flowing between source and drain is controlled by the voltage between the gate and the source.

Transistors can also be classified as p-type and n-type according to whether they comprise semi-conductive material which conducts positive charge carriers (holes) or negative charge carriers (electrons) respectively. The semi-conductive material may be selected according to its ability to accept, conduct, and donate charge. The ability of the semi-conductive material to accept, conduct, and donate holes or electrons can be enhanced by doping the material. The material used for the source and drain electrodes can also be selected according to its ability to accept and inject holes or electrodes.

For example, a p-type transistor device can be formed by selecting a semi-conductive material which is efficient at accepting, conducting, and donating holes, and selecting a material for the source and drain electrodes which is efficient at injecting and accepting holes from the semi-conductive material. Good energy-level matching of the Fermi-level in the electrodes with the HOMO level of the semi-conductive material can enhance hole injection and acceptance. In contrast, an n-type transistor device can be formed by selecting a semi-conductive material which is efficient at accepting, conducting, and donating electrons, and selecting a material for the source and drain electrodes which is efficient at injecting electrons into, and accepting electrons from, the semi-conductive material. Good energy-level matching of the Fermi-level in the electrodes with the LUMO level of the semi-conductive material can enhance electron injection and acceptance. Ambipolar devices that can function as n-type or p-type devices are also known.

Transistors can be formed by depositing the components in thin films to form a thin film transistor (TFT). When an organic material is used as the semi-conductive material in such a device, it is known as an organic thin film transistor (OTFT).

Various arrangements for organic thin film transistors are known. One such device is an insulated gate field-effect transistor which comprises source and drain electrodes with a semi-conductive material disposed therebetween in a channel region, a gate electrode disposed adjacent the semi-conductive material and a layer of insulting material disposed between the gate electrode and the semi-conductive material in the channel region.

OTFTs may be manufactured by low cost, low temperature methods such as solution processing. Moreover, OTFTs are compatible with flexible plastic substrates, offering the prospect of large-scale manufacture of OTFTs on flexible substrates in a roll-to-roll process.

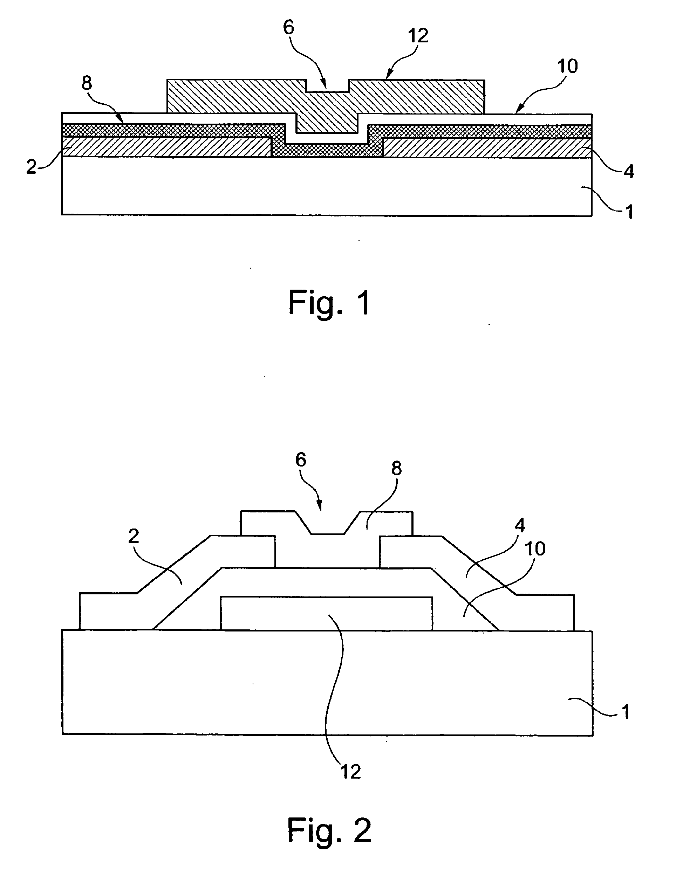

An example of such an organic thin film transistor is shown in Figure 1. The illustrated structure may be deposited on a substrate 1 and comprises source and drain electrodes 2, 4 which are spaced apart with a channel region 6 located therebetween. An organic semiconductor (OSC) 8 is deposited in the channel region 6 and may extend over at least a portion of the source and drain electrodes 2, 4. An insulating layer 10 of dielectric material is deposited over the organic semiconductor 8 and may extend over at least a portion of the source and drain electrodes 2, 4. Finally, a gate electrode 12 is deposited over the insulating layer 10. The gate electrode 12 is located over the channel region 6 and may extend over at least a portion of the source and drain electrodes 2, 4.

The structure described above is known as a top-gate organic thin film transistor as the gate is located on a top side of the device. Alternatively, it is also known to provide the gate on a bottom side of the device to form a so-called bottom-gate organic thin film transistor.

An example of such a bottom-gate organic thin film transistor is shown in Figure 2. In order to more clearly show the relationship between the structures illustrated in Figures 1 and 2, like reference numerals have been used for corresponding parts. The bottom-gate structure illustrated in Figure 2 comprises a gate electrode 12 deposited on a substrate 1 with an insulating layer 10 of dielectric material deposited thereover. Source and drain electrodes 2, 4 are deposited over the insulating layer 10 of dielectric material. The source and drain electrodes 2, 4 are spaced apart with a channel region 6 located therebetween over the gate electrode. An organic semiconductor (OSC) 8 is deposited in the channel region 6 and may extend over at least a portion of the source and drain electrodes 2, 4.

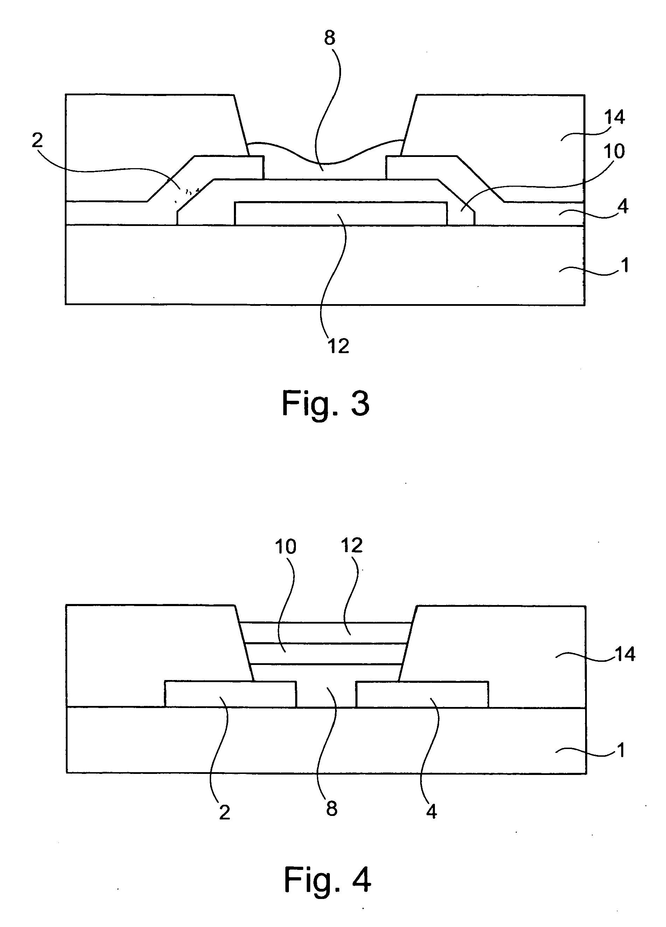

One problem with the aforementioned arrangements is how to contain the OSC within the channel region when it is deposited. A solution to this problem is to provide a patterned layer of insulating bank material 14 defining a well in which the OSC 8 can be deposited from solution by, for example, inkjet printing. Such an arrangement is shown in Figures 3 and 4 for bottom and top gate organic thin film transistors respectively. Again, in order to more clearly show the relationship between the structures illustrated in Figures 1 and 2, with those illustrated in Figures 3 and 4, like reference numerals have been used for corresponding parts.

The periphery of the well defined by the patterned layer of insulating material 14 surrounds some or all of the channel 6 defined between the source and drain electrodes 2, 4 in order to facilitate deposition of the OSC 8 by, for example, inkjet printing. Furthermore, as the insulating layer 14 is deposited prior to deposition of the OSC 8, it may be deposited and patterned without damaging the OSC. The structure of the insulating layer 14 can be formed in a reproducible manner using known deposition and patterning techniques such as photolithography of positive or negative resists, wet etching, dry etching, etc.

Even if a patterned layer of well-defining bank material is provided, problems still exist in containing the OSC within the channel region and providing good film formation of the OSC in the channel region using solution processing techniques for deposition of the OSC. Uncontrollable wetting of the well-defining bank layer may occur since the contact angle of the OSC solution on the well-defining bank layer is typically low. In the worst case the OSC may overspill the wells.

Organic light emissive devices are discussed in more detail below.

Displays fabricated using OLEDs (organic light emitting devices) provide a number of advantages over other flat panel technologies. They are bright, colourful, fast-switching, provide a wide viewing angle, and are easy and cheap to fabricate on a variety of substrates. Organic (which here includes organometallic) light emitting diodes (LEDs) may be fabricated using materials including polymers, small molecules and dendrimers, in a range of colours which depend upon the materials employed. Examples of polymer-based organic LEDs are described in WO 90/13148, WO 95/06400 and WO 99/48160. Examples of dendrimer-based materials are described in WO 99/21935 and WO 02/067343. Examples of so called small molecule based devices are described in US 4,539,507.

A typical OLED device comprises two layers of organic material, one of which is a layer of light emitting material such as a light emitting polymer (LEP), oligomer or a light emitting low molecular weight material, and the other of which is a layer of a hole injecting material such as a polythiophene derivative or a polyaniline derivative.

OLEDs may be deposited on a substrate in a matrix of pixels to form a single or multi-colour pixellated display. A multicoloured display may be constructed using groups of red, green, and blue emitting pixels. So-called active matrix displays have a memory element, typically a storage capacitor and a thin film transistor (TFT), associated with each pixel whilst passive matrix displays have no such memory element and instead are repetitively scanned to give the impression of a steady image. Other passive displays include segmented displays in which a plurality of segments share a common electrode and a segment may be lit up by applying a voltage to its other electrode. A simple segmented display need not be scanned but in a display comprising a plurality of segmented regions the electrodes may be multiplexed (to reduce their number) and then scanned.

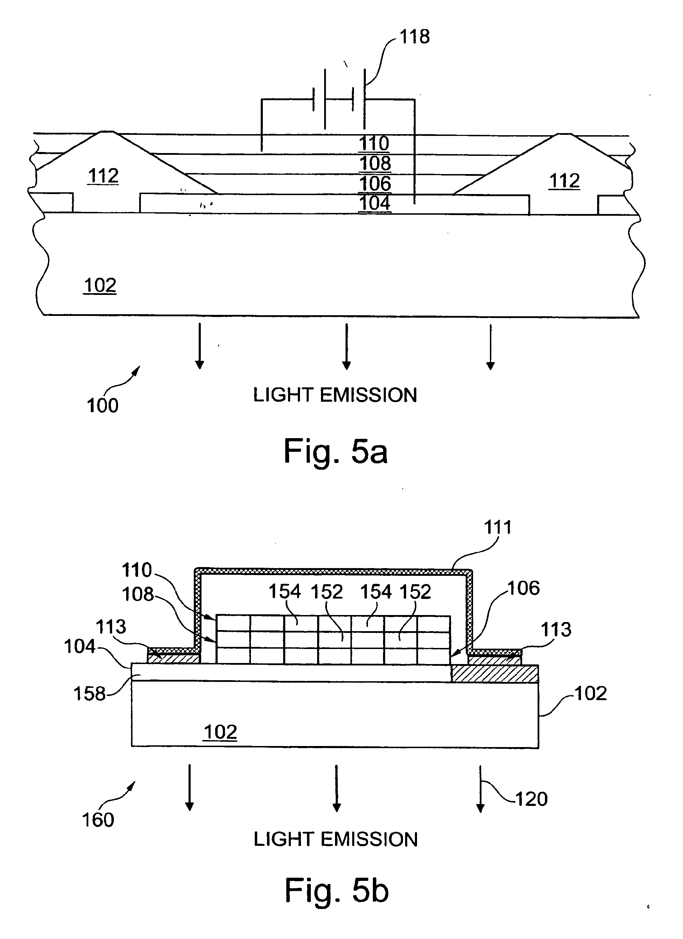

Figure 5 shows a vertical cross section through an example of an OLED device 100. In an active matrix display, part of the area of a pixel is occupied by associated drive circuitry (not shown in Figure 5). The structure of the device is somewhat simplified for the purposes of illustration.

The OLED 100 comprises a substrate 102, typically 0.7 mm or 1.1 mm glass but optionally clear plastic or some other substantially transparent material. An anode layer 104 is deposited on the substrate, typically comprising around 40 to 150 nm thickness of ITO (indium tin oxide), over part of which is provided a metal contact layer. Typically the contact layer comprises around 500nm of aluminium, or a layer of aluminium sandwiched between layers of chrome, and this is sometimes referred to as anode metal. Glass substrates coated with ITO and contact metal are widely available. The contact metal over the ITO helps provide reduced resistance pathways where the anode connections do not need to be transparent, in particular for external contacts to the device. The contact metal is removed from the ITO where it is not wanted, in particular where it would otherwise obscure the display, by a standard process of photolithography followed by etching.

A substantially transparent hole injection layer 106 is deposited over the anode layer, followed by an electroluminescent layer 108, and a cathode 110. The electroluminescent layer 108 may comprise, for example, a PPV (poly(p- phenylenevinylene)) and the hole injection layer 106, which helps match the hole energy levels of the anode layer 104 and electroluminescent layer 108, may comprise a conductive transparent polymer, for example PEDOT:PSS (polystyrene-sulphonate doped polyethylene-dioxythiophene) from H.C. Starck of Germany. In a typical polymer-based device the hole transport layer 106 may comprise around 200 nm of PEDOT. The light emitting polymer layer 108 is typically around 70 nm in thickness. These organic layers may be deposited by spin coating (afterwards removing material from unwanted areas by plasma etching or laser ablation) or by inkjet printing. In this latter case, banks 112 may be formed on the substrate, for example using photoresist, to define wells into which the organic layers may be deposited. Such wells define light emitting areas or pixels of the display.

Cathode layer 110 typically comprises a low work function metal such as calcium or barium (for example deposited by physical vapour deposition) covered with a thicker, capping layer of aluminium. Optionally an additional layer may be provided immediately adjacent the electroluminescent layer, such as a layer of lithium fluoride, for improved electron energy level matching. Mutual electrical isolation of cathode lines may be achieved or enhanced through the use of cathode separators (not shown in Figure 5).

The same basic structure may also be employed for small molecule devices.

Typically a number of displays are fabricated on a single substrate and at the end of the fabrication process the substrate is scribed, and the displays separated before an encapsulating can is attached to each to inhibit oxidation and moisture ingress. Alternatively, the displays can be encapsulated prior to scribing and separating.

To illuminate the OLED, power is applied between the anode and cathode by, for example, battery 118 illustrated in Figure 5. In the example shown in Figure 5 light is emitted through transparent anode 104 and substrate 102 and the cathode is generally reflective. Such devices are referred to as "bottom emitters". Devices which emit through the cathode ("top emitters") may also be constructed, for example, by keeping the thickness of cathode layer 110 less than around 50-100 nm so that the cathode is substantially transparent and/or using a transparent cathode material such as ITO.

Referring now to Figure 5b, this shows a simplified cross-section through a passive matrix OLED display device 150, in which like elements to those of Figure 5 are indicated by like reference numerals. As shown, the hole transport layer 106 and the electroluminescent layer 108 are subdivided into a plurality of pixels 152 at the intersection of mutually perpendicular anode and cathode lines defined in the anode metal 104 and cathode layer 110 respectively. In the figure conductive lines 154 defined in the cathode layer 110 run into the page and a cross-section through one of a plurality of anode lines 158 running at right angles to the cathode lines is shown. An electroluminescent pixel 152 at the intersection of a cathode and anode line may be addressed by applying a voltage between the relevant lines. The anode metal layer 104 provides external contacts to the display 150 and may be used for both anode and cathode connections to the OLEDs (by running the cathode layer pattern over anode metal lead-outs).

The above mentioned OLED materials, and in particular the light emitting polymer material and the cathode, are susceptible to oxidation and to moisture. The device is therefore encapsulated in a metal or glass can 111, attached by UV-curable epoxy glue 113 onto anode metal layer 104. Preferably the anode metal contacts are thinned where they pass under the lip of the metal can 111 to facilitate exposure of glue 113 to UV light for curing.

Considerable effort has been dedicated to the realization of a full-colour, all plastic display. The major challenges to achieving this goal have been: (1) access to conjugated polymers emitting light of the three basic colours red, green and blue; and (2) the conjugated polymers must be easy to process and fabricate into full-colour display structures. Polymer light emitting devices (PLEDs) show great promise in meeting the first requirement, since manipulation of the emission colour can be achieved by changing the chemical structure of the conjugated polymers. However, while modulation of the chemical nature of conjugated polymers is often easy and inexpensive on the lab scale it can be an expensive and complicated process on the industrial scale. The second requirement of easy processability and build-up of full-colour matrix devices raises the question of how to micro-pattern fine multicolour pixels and how to achieve full-colour emission. Inkjet printing and hybrid inkjet printing technology have attracted much interest for the patterning of PLED devices (see, for example, Science 1998, 279, 1135; Wudl et al, Appl Phys. Lett. 1998, 73, 2561; and J. Bharathan, Y. Yang, Appl. Phys. Lett. 1998, 72, 2660).

In order to contribute to the development of a full-colour display, conjugated polymers exhibiting direct colour-tuning, good processability and the potential for inexpensive large-scale fabrication have been sought. Poly-2,7-fluorenes have been the subject of much research into blue-light emitting polymers (see, for example, A. W. Grice, D. D. C. Bradley, M. T. Bernius, M. Inbasekaran, W. W. Wu, and E. P. Woo, Appl. Phys. Lett. 1998, 73, 629; J. S. Kim, R. H. Friend, and F. Cacialli, Appl. Phys. Lett. 1999, 74, 3084; WO-A-00/55927 and M. Bernius et a.l, Adv. Mater., 2000, 12, No. 23, 1737).

Active matrix organic light-emitting devices (AMOLEDs) are known in the art wherein electroluminescent pixels and a cathode are deposited onto a glass substrate comprising active matrix circuitry for controlling individual pixels and a transparent anode. Light in these devices is emitted towards the viewer through the anode and the glass substrate (so-called bottom-emission). Devices with transparent cathodes (so-called "top-emitting" devices) have been developed as a solution to this problem. A transparent cathode must possess the following properties: transparency; conductivity; and low workfunction for efficient electron injection into the LUMO of the electroluminescent layer of the device or, if present, an electron transporting layer.

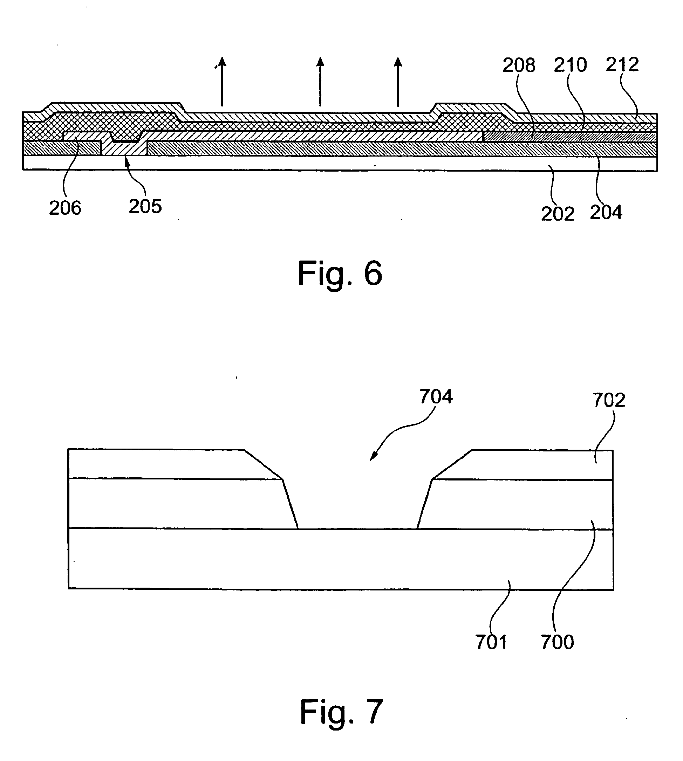

An Example of a top-emitting device is shown in Figure 6. The top-emitting device comprises a substrate 202 on which an insulating planarization layer 204 is disposed. A via hole is provided in the planarization layer 204 so an anode can be connected to its associated TFT (not shown). An anode 206 is disposed on the planarization layer 204 over which well-defining banks 208 are provided. The anode 206 is preferably reflective. Electroluminescent material 210 is disposed in the wells defined by the banks and a transparent cathode 212 is deposited over the wells and the banks to form a continuous layer.

Inkjet printing of electroluminescent formulations is a cheap and effective method of forming patterned devices. As disclosed in EP-A-0880303, this entails use of photolithography to form wells that define pixels into which the organic electroluminescent material is deposited by inkjet printing.

Even if a patterned layer of well-defining bank material is provided, problems still exist in containing the organic charge injection material, organic charge transport material and/or organic electroluminescent material within the wells and providing good film formation of the organic layers using solution processing techniques for deposition of the organic materials. Uncontrollable wetting of the well-defining bank layer may occur since the contact angle of the organic solutions on the well-defining bank layer is typically low. In the worst case the organic material may overspill the wells.

One known solution to the aforementioned problem is to treat the well-defining layer with a fluorine based plasma to decrease the wettability of an upper surface of the well-defining bank layer. However, the present applicant has found that there are some problems associated with such treatments. Treatments to reduce the wettability of the insulating bank layer are generally unstable and the treated surface tends to revert to its original wettability over a period of time, particularly if subjected to further processing steps. Thus, if the insulating layer is treated in order to reduce its surface wettability prior to patterning to form wells, by the time the wells have been formed and the active organic material is ready to be deposited, the surface tends to have reverted towards its original wettability. Alternatively, if the wells are formed first and then a surface treatment is applied, such surface treatments have been found to damage circuit components exposed in the well.

Having identified these problems, the present applicant has realized that they may be solved by using a double bank well-defining structure, the double bank well-defining structure being formed by depositing a first layer of insulating material and then depositing a second layer of insulating material thereover, the second layer of insulating material having a lower wettability than the first layer of insulating material as described in co-pending application GB 0724773.7. The second layer is formed of an inherently low-wettability (high contact angle) material forming a separate and distinct layer as opposed to a treated surface of the first layer in which the chemical nature of the surface of the first layer is modified. Such a double bank well-defining structure provides a more robust low-wetting upper surface and avoids surface treatments which damage circuit components exposed in the well.

It is an aim of the present invention to improve on the devices and methods of manufacture described above.

### Summary of the Present Invention

Despite the aforementioned double bank well-defining structure solving some of the problems associated with plasma treatment methods, the present applicant has identified some problems associated with the double bank well-defining structure. The double bank well-defining structure requires two deposition steps to form the first and second layers thus increasing time, complexity and expense in the manufacturing process when compared to a single bank well-defining structure. Furthermore, the present applicant has found that there can be poor adhesion between the two layers of material in the double bank structure. This is due to the non-stick properties of the low-wettability materials used for the second layer and can lead to delamination of the layers reducing the robustness and lifetime of the organic electronic device. Accordingly, the present applicant has found that it can be beneficial to provide an adhesive layer between the two layers. However, this requires yet another deposition step thus increasing time, complexity and expense in the manufacturing process yet further.

Having identified these problems, the present applicant has sought to resolve the problem of poor adhesion and delamination of layers in the double bank structure while also avoiding the additional deposition steps mentioned above.

In light of the above, in according to a first aspect of the present invention there is provided a method of manufacturing an organic electronic device, the method comprising: providing a substrate; forming a well-defining structure over the substrate; and depositing a solution of organic semiconductive material and/or organic conductive material in wells defined by the well-defining structure, wherein the well-defining structure is formed by depositing a solution comprising a mixture of a first insulating material and a second insulating material, the second insulating material having a lower wettability than the first insulating material, and allowing the first and second insulating materials to at least partially phase separate wherein the second insulating material phase separates in a direction away from the substrate.

The second insulating material has a lower wettability and phase separates towards the upper surface, i.e. in a direction away from the substrate. This results in an upper part of the well-defining structure having a lower wettability than a lower part of the well-defining structure. The present applicant has found that a well-defining structure formed in this manner functions well to contain a solution of organic semiconductive material and/or organic conductive material. Furthermore, the present applicant has found that good even films of organic semiconductive material and/or organic conductive material are formed in a well-defining structure formed in this manner. Further still, the present applicant has found that by forming the well-defining structure in this manner, the first and second materials can be more strongly adhered together when compared with separate deposition of layers and the problem of poor adhesion and delamination is reduced or eliminated.

All the aforementioned advantageous features can be achieved utilizing a single deposition step for forming the well-defining structure thus reducing time, complexity and expense in the manufacturing process.

According to one embodiment of the present invention the first and second materials completely phase separate in order to form two distinct and separate layers. According to other embodiments, the first and second materials partially phase separate such that at least a portion of the well-defining structure comprises a mixture of the first and second materials. The upper surface of the well-defining structure (on an opposite side to the substrate) may comprise substantially no first insulating material. The lower surface of the well-defining structure (adjacent the substrate) may comprise substantially no second insulating material. An intermediate zone may comprise a mixture of the first and second insulating material. One advantageous feature of such an intermediate zone is that it aids in binding the upper and lower zones together to prevent delamination of the first and second insulating materials.

The step of allowing the first and second insulating materials to phase separate may be performed prior to forming the wells in the well-defining structure. Alternatively, the wells may be formed after depositing the mixture of the first insulating material and the second insulating material and prior to phase separation. However, this tends to result in the low wettability material phase separating to cover the sides of the wells in addition to an upper surface of the well-defining structure which can lead to poor film formation in the wells if the solution of active organic material deposited in the wells does not sufficiently wet the sides of the wells. In this case, it may be necessary to remove some low-wettability material from the sides of the wells prior to depositing the active organic material therein. For this reason, it may be advantageous to allow the first and second insulating materials to phase separate prior to forming the wells in the well-defining structure.

A baking step may be used to encourage the first and second insulating materials to phase separate either before or after the wells are formed depending on which of the aforementioned methods is utilized.

In order to form a well-defining structure with wetting side walls and a de-wetting top surface the contact angle (wettability) of the insulating materials is important. The wettability of the insulating materials also effects phase separation of the materials. The contact angle of the first material with water may be less than 60°, preferably less than 50 °, more preferably less than 40 ° and most preferably less than 30 °. The contact angle of the second material with water may be greater than 60 °, preferably greater than 70 °, more preferably greater than 80 ° and most preferably greater than 90 °. Preferably, the difference between the contact angles of the first and second materials with water is at least 20 °. This difference in wettability encourages phase separation.

Preferably the first and/or second insulating materials are organic materials, most preferably polymer materials.

The first insulating material may be a photopatternable resist such as polyimide, spin-on-glass or BCB.

The second insulating material may be a fluorinated polymer. The fluorine containing groups may be provided in repeat units of the polymer backbone, in side chains pendant to the polymer backbone, or in end groups. Examples of suitable polymers include fluoroalkyl methacrylate polymers and fluoroalcohol methacrylate polymers. Such materials have low-wettability.

Another problem is that certain low-wettability materials have been found to migrate off the top of the well-defining structure into the wells. It is not desired to have de-wetting material in the wells as this can adversely affect film formation or the active organic material in the wells. The aforementioned materials for the second insulating material are relatively immobile and remain on the top of the well-defining structure.

The wells may be formed using known patterning techniques such as photolithography of positive or negative resists, wet etching, dry etching (e.g. plasma etching), etc.

One possible problem with allowing the first and second insulating materials to phase separate prior to forming the wells in the well-defining structure is that certain low-wettability materials can be difficult to pattern. For example, if the wells are formed using photopatterning techniques that involve UV exposure and developing, certain developers may not wet the low-wettability material sufficiently to form the wells after UV exposure. In this case, the concentration of low-wettability material in the mixture may be reduced such that only a thin layer of low-wettability material is formed on the well-defining structure after phase separation. For example, the well-defining structure may comprise 20% by weight or less of the second insulating material or even 10% by weight or less of the second insulating material, for example 1 to 5% by weight. The thickness of the well-defining structure may be 100nm to 10 µm. An upper portion of the well-defining structure containing the low-wettability material may have a thickness less than 30nm, 20nm or even 10nm or less.

Alternatively or additionally, the developer and/or low-wettability material can be selected such that the developer wets the low-wettability material sufficiently to form the well-defining structure but the low-wettability material is still sufficiently low-wetting to act as a de-wetting surface for containment of the active organic material in the wells. Fluoroalkyl methacrylate polymers and fluoroalcohol methacrylate polymers are possible examples of such low-wettability materials. The low-wettability material may comprise solubilising groups to increase solubility in developer. The solubilising groups may be provided in repeat units of the polymer backbone, in side chains pendant to the polymer backbone, or in end groups. Suitable solubilising groups include alkyl chains, carbocylic acids, and esters. A surfactant may also be added to the developer in order to reduce the effective contact angle of the developer on the low-wettability material to encourage wetting and improve development.

The organic semiconductive/conductive material may be deposited in an aqueous solution or alternatively an organic solvent may be used. Inkjet printing is the preferred method for depositing the solution of organic semiconductive/conductive material in the wells defined by the double bank well-defining structure. However, using a well-defining structure in which the top layer has a very low wettability (a very high contact angle), other solution processing techniques are possible. For example, the solution may be deposited in a less discriminate manner over the substrate, e.g. flood printing, and the very high contact angle top-layer of the bank structure ensures that the solution flows into the wells such that none of the solution remains over the bank structure.

The present applicant has found that certain fluorinated polymers such as Cytop have a much higher contact angle, and are thus a much lower wettability, than other fluorinated polymers, for example, greater than 80°. The present applicant has found that these very high contact angle polymers have certain disadvantages for use in single layer bank structures, i.e. they result in active organic films which are not uniform in thickness as described previously. Furthermore, they may delaminate if deposited as a separate layer to form a double bank well-defining structure. However, they may be used in a phase separated well-defining structure in accordance with embodiments of the present invention while avoiding the aforementioned disadvantages.

With the aforementioned very low wettability materials, the contact angle of the second insulating material may be 100° or more. Examples of very high contact angle materials include Cytop-type materials from Aldrich. An example of a Cytop-type material is Poly-1,1,2,4,4,5,5,6,7,7-decafluoro-3-oxa-1,6-heptadiene which has a contact angle of approximately 135°. This may be provided in a solvent of perfluorotrialkylamine. Other examples include Cytop from Asahi Glass, Teflon AF from DuPont, and Fluorolink materials from Solvay Solexis. Such materials have been found to be useful for containment of organic material deposited from aqueous solution, for example, aqueous solutions of conductive polymers, particularly hole injecting polymers such as PEDOT. Such materials are also useful for containment of organic material deposited from organic solvents. As such, a well-defining structure comprising such a material can be used, for example, when depositing a hole injecting layer from aqueous solution and a light-emissive layer from an organic solvent to form an organic light emissive device.

The present applicant has yet further found that baking can decrease the wettability of the second insulating material. As such, they have found it beneficial to provide a baking step prior to deposition of active organic material from solution. The bake may be at a temperature in the range 100 to 250°, more preferably, 100 to 200°, most preferably 100 to 170°. The bake may be performed in an inert atmosphere such as N₂ or in air.

Yet another problem that the present applicant has identified is that after forming the wells in a bank structure, it is desirable to provide a cleaning step such as an O₂ or ozone plasma treatment. Such a step cleans the surfaces in the wells and increases wettability of these surfaces prior to deposition of organic material therein. However, the present applicant has found that such a step greatly increases the wettability of surfaces of the bank which have been previously treated with, for example, a fluorine based plasma treatment in order to decrease their wettability. In fact, contact angles of such a treated surface can drop to under 10° after such a cleaning step. As such, when containment of organic material in the wells has been an issue, such a cleaning step had to be avoided. In contrast, the present applicant has found that when using a well-defining structure as described herein, the cleaning step can be performed while retaining good de-wetting characteristics over the bank.

In one particular embodiment, the previously described baking step is performed after the cleaning step and prior to depositing the solution of organic material in wells defined by the double bank well-defining structure. The baking step has been found to regenerate a low-wettability surface on the bank after cleaning using, for example, an O₂ or ozone plasma.

The present applicant has also found that it is advantageous in certain circumstances to form a well-defining structure such that the first and second insulating materials define a step structure around the wells. Such a step structure can allow the wells to be overfilled with solution. Such a structure can also provide two different pinning points for different fluids deposited in the wells, one at an edge of the first layer around the well and one at an edge of the second layer stepped back from the well. This can ensure, for example, that on drying a second material deposited in the wells completely covers a first material deposited in the wells, particularly around the edges of the wells. The different fluids may be selected to have different wetting capabilities, for example, one of the fluids may be an aqueous solution and the other of the fluids may comprise an organic solvent.

According to another embodiment of the present invention, the well-defining structure may comprise discrete rings which define the perimeter of at least one well without extending to the perimeter of adjacent wells. This so-called "ring bank" arrangement comprises a plurality of discrete rings of bank material and is described in the present applicant's co-pending application PCT/GB2007/003595. This arrangement contrasts with a conventional bank structure which is basically a continuous sheet with a plurality of holes (wells) formed therein.

According to a second aspect of the present invention there is provided an electronic device comprising: a substrate; a well-defining structure disposed over the substrate; and organic semiconductive and/or organic conductive material disposed in wells defined by the well-defining structure, wherein the well-defining structure comprises a first insulating material and a second insulating material, the second insulating material having a lower wettability than the first insulating material, wherein the second insulating material has a concentration which increases in a direction away from the substrate.

According to preferred embodiments, the well-defining structure is for active organic material to be deposited over an electronic substrate comprising circuit elements, as other methods of decreasing wettability such as plasma treatments have been found to damage the underlying electronic circuitry of the substrate exposed in the wells.

The organic semiconductive material may form the active layer of an OTFT or an active layer of an OLED.

In the case of an OTFT, the circuit elements of the electronic substrate comprise source and drain electrodes over which the double bank structure is disposed with a channel region defined between the source and drain electrodes. For a bottom-gate OTFT, the electronic substrate also comprises a gate electrode with a gate dielectric disposed thereover, the source and drain electrodes being disposed over the gate dielectric. The present invention has been found to be particularly useful for bottom gate OTFTs as the gate dielectric in the channel region exposed in the well defined by the bank structure has been found by the present applicant to be particularly sensitive to alternative treatment methods such as fluorine based plasma treatments.

In the case of an OLED, the circuit elements of the electronic substrate comprise a lower electrode of the OLED. In an active matrix OLED display device, the circuit elements of the electronic substrate also comprise an OTFT which itself may be formed using a double bank structure in accordance with the present invention.

According to preferred embodiments there is provided an organic thin film transistor or an organic light-emissive device manufactured according to the previously described structures and methods. According to certain embodiments there is provided an active matrix organic optical device and method of making the same in which an organic thin film transistor and an organic light-emissive device are provided according to the previously described structures and methods.

### Summary of the Drawings

The present invention will now be described in further detail, by way of example only, with reference to the accompanying drawings in which:
Figure 1 shows a known top-gate organic thin film transistor arrangement;
Figure 2 shows a known bottom-gate organic thin film transistor arrangement;
Figure 3 shows a bottom-gate organic thin film transistor arrangement with a well for containing the organic semiconductor;
Figure 4 shows a top-gate organic thin film transistor arrangement with a well for containing the organic semiconductor;
Figure 5a shows a bottom-emitting organic light emitting device according to the prior art;
Figure 5b shows a bottom-emitting organic light emitting display according to the prior art;
Figure 6 shows a top-emitting organic light emitting device according to the prior art;
Figure 7 shows a well-defining structure according to an embodiment of the present invention;
Figure 8 shows the method steps involved in forming a double bank structure according to an embodiment of the present invention;
Figure 9 shows another well-defining structure according to an embodiment of the present invention;
Figure 10 illustrates a portion of an active matrix organic light emitting display comprising an organic thin film transistor and an organic light emitting device; and
Figure 11 illustrates a portion of another active matrix organic light emitting display arrangement comprising an organic thin film transistor and an organic light emitting device.

### Detailed Description of Preferred Embodiments

Embodiments of the present invention relate to printed organic electronic devices which comprise a patterned well-defining bank structure. Embodiments seek to provide a bank structure in which the side walls of the wells are wetting whereas the top of the bank structure is anti wetting. Embodiments also seek to provide a manufacturing process that involves no plasma processes using fluorine based gas systems which have been found to damage circuitry elements or device layers exposed in the wells. Embodiments have the potential for obtaining good device performance whilst retaining optimum printing performance during deposition of the active organic material of the device from solution.

Figure 7 shows a well-defining structure according to an embodiment of the present invention. The well-defining structure is disposed on an electronic substrate 701 and comprises a lower portion 700 of wettable material and an upper portion 702 of an inherently low wettability (high contact angle) material. The two portions of the well-defining structure are formed by depositing a solution comprising a mixture of wettable and low wettability material and allowing the materials to phase separate to form the upper and lower portions of the well-defining structure. Wells 704 can be formed in the well-defining structure using a single lithography process and are automatically self-aligned.

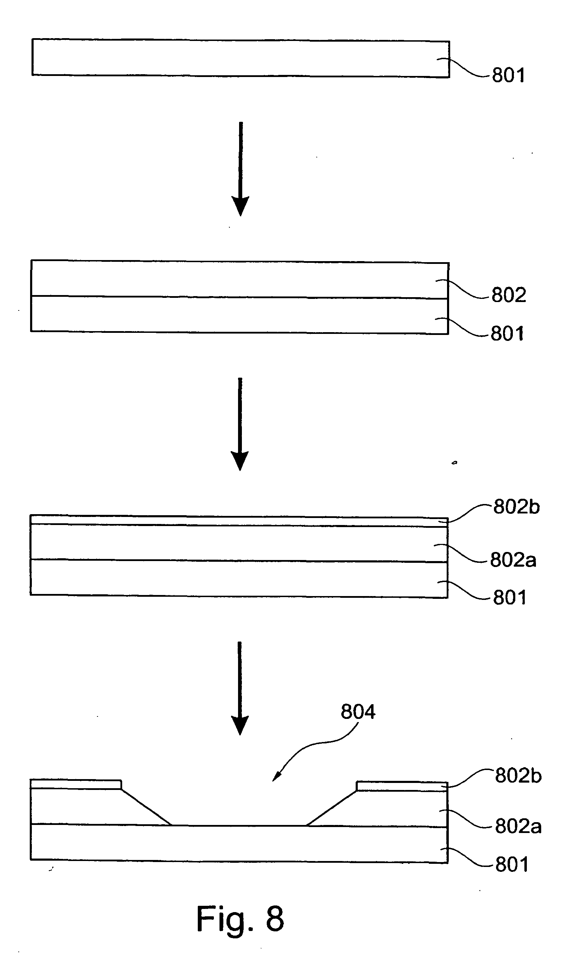

Figure 8 shows the method steps involved in forming a well-defining structure according to an embodiment of the present invention. First, a solution 802 containing a mixture of a wettable material and a low-wettability material is deposited by, for example, spin coating on an electronic substrate 801. Next, the materials are allowed to phase separate to form a lower wetting region 802a and an upper de-wetting region 802b. The structure may optionally be baked to encourage phase separation. A well 804 is then formed in the phase separated layer. The wettable material may optionally be cross linked by, for example, UV flood exposure.

Various possibilities are available for forming the wells. For example, the phase separated layer can be optionally exposed to an O₂ or ozone plasma treatment to aid wetting and a thick layer of resist can be spin coated, UV exposed and developed to define a mask. An O₂ plasma etch can then be used to form the wells. Any excess material from the mask can also be removed. Just before active layers are deposited in the wells, the structure can be exposed to an O₂ plasma to clean the surfaces of the structure followed by a high temperature cure, e.g. in air at 150°C to regenerate hydrophobic surfaces.

As an alternative to the above, the wells can be formed by photopatterning the phase separated layer including UV exposure and developing to dissolve away portions of the phase separated layer in order to form the wells.

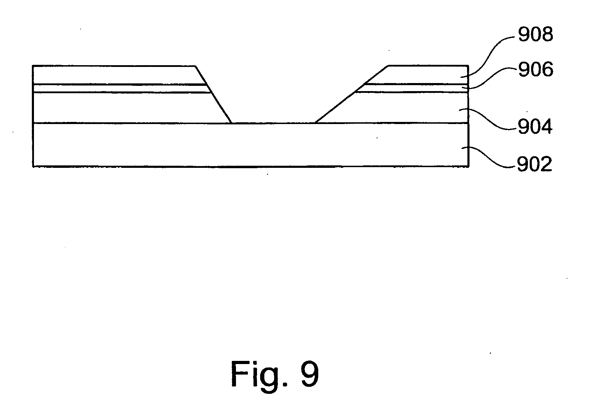

Figure 9 shows a well-defining structure on a substrate 902 according to another embodiment of the present invention comprising three zones: a lower zone 904 comprising substantially no second insulating material adjacent the substrate; an upper zone 908 comprising substantially no first insulating material on an opposite side to the substrate; and an intermediate zone 906 comprising a mixture of the first and second insulating material.

Materials and processes suitable for forming an OTFT in accordance with embodiments of the present invention are discussed in further detail below.

### Substrate

The substrate may be rigid or flexible. Rigid substrates may be selected from glass or silicon and flexible substrates may comprise thin glass or plastics such as poly(ethylene-terephthalate) (PET), poly(ethylene-naphthalate) PEN, polycarbonate and polyimide.

The organic semiconductive material may be made solution processable through the use of a suitable solvent. Exemplary solvents include: mono- or poly-alkylbenzenes such as toluene and xylene; tetralin; and chloroform. Preferred solution deposition techniques include spin coating and ink jet printing. Other solution deposition techniques include dip-coating, roll printing and screen printing.

### Organic semiconductor materials

Preferred organic semiconductor materials include: small molecules such as optionally substituted pentacene; optionally substituted polymers such as polyarylenes, in particular polyfluorenes and polythiophenes; and oligomers. Blends of materials, including blends of different material types (e.g. a polymer and small molecule blend) may be used.

### Source and drain electrodes

For a p-channel OTFT, preferably the source and drain electrodes comprise a high workfunction material, preferably a metal, with a workfunction of greater than 3.5eV, for example gold, platinum, palladium, molybdenum, tungsten, or chromium. More preferably, the metal has a workfunction in the range of from 4.5 to 5.5 eV. Other suitable compounds, alloys and oxides such as molybdenum trioxide and indium tin oxide may also be used. The source and drain electrodes may be deposited by thermal evaporation and patterned using standard photolithography and lift off techniques as are known in the art.

Alternatively, conductive polymers may be deposited as the source and drain electrodes. An example of such a conductive polymers is poly(ethylene dioxythiophene) (PEDOT) although other conductive polymers are known in the art. Such conductive polymers may be deposited from solution using, for example, spin coating or ink jet printing techniques and other solution deposition techniques discussed above.

For an n-channel OTFT, preferably the source and drain electrodes comprise a material, for example a metal, having a workfunction of less than 3.5eV such as calcium or barium or a thin layer of metal compound, in particular an oxide or fluoride of an alkali or alkali earth metal for example lithium fluoride, barium fluoride and barium oxide. Alternatively, conductive polymers may be deposited as the source and drain electrodes.

The source and drain electrodes are preferably formed from the same material for ease of manufacture. However, it will be appreciated that the source and drain electrodes may be formed of different materials for optimisation of charge injection and extraction respectively.

The length of the channel defined between the source and drain electrodes may be up to 500 microns, but preferably the length is less than 200 microns, more preferably less than 100 microns, most preferably less than 20 microns.

### Gate electrode

The gate electrode can be selected from a wide range of conducting materials for example a metal (e.g. gold) or metal compound (e.g. indium tin oxide). Alternatively, conductive polymers may be deposited as the gate electrode. Such conductive polymers may be deposited from solution using, for example, spin coating or ink jet printing techniques and other solution deposition techniques discussed above

Thicknesses of the gate electrode, source and drain electrodes may be in the region of 5 - 200nm, although typically 50nm as measured by Atomic Force Microscopy (AFM), for example.

### Gate dielectric

The gate dielectric comprises a dielectric material selected from insulating materials having a high resistivity. The dielectric constant, k, of the dielectric is typically around 2-3 although materials with a high value of k are desirable because the capacitance that is.achievable for an OTFT is directly proportional to k, and the drain current I_{D} is directly proportional to the capacitance. Thus, in order to achieve high drain currents with low operational voltages, OTFTs with thin dielectric layers in the channel region are preferred.

The dielectric material may be organic or inorganic. Preferred inorganic materials include Si02, SiNx and spin-on-glass (SOG). Preferred organic materials are generally polymers and include insulating polymers such as poly vinylalcohol (PVA), polyvinylpyrrolidine (PVP), acrylates such as polymethylmethacrylate (PMMA) and benzocyclobutanes (BCBs) available from Dow Coming. The insulating layer may be formed from a blend of materials or comprise a multilayered structure.

The dielectric material may be deposited by thermal evaporation, vacuum processing or lamination techniques as are known in the art. Alternatively, the dielectric material may be deposited from solution using, for example, spin coating or ink jet printing techniques and other solution deposition techniques discussed above.

If the dielectric material is deposited from solution onto the organic semiconductor, it should not result in dissolution of the organic semiconductor. Likewise, the dielectric material should not be dissolved if the organic semiconductor is deposited onto it from solution. Techniques to avoid such dissolution include: use of orthogonal solvents, i.e. use of a solvent for deposition of the uppermost layer that does not dissolve the underlying layer; and crosslinking of the underlying layer.

The thickness of the gate dielectric layer is preferably less than 2 micrometres, more preferably less than 500 nm.

### Further layers

Other layers may be included in the device architecture. For example, a self assembled monolayer (SAM) may be deposited on the gate, source or drain electrodes, substrate, insulating layer and organic semiconductor material to promote crystallity, reduce contact resistance, repair surface characteristics and promote adhesion where required. In particular, the dielectric surface in the channel region may be provided with a monolayer comprising a binding region and an organic region to improve device performance, e.g. by improving the organic semiconductor's morphology (in particular polymer alignment and crystallinity) and covering charge traps, in particular for a high k dielectric surface. Exemplary materials for such a monolayer include chloro- or alkoxy-silanes with long alkyl chains, e.g. octadecyltrichlorosilane. Similarly, the source and drain electrodes may be provided with a SAM to improve the contact between the organic semiconductor and the electrodes. For example, gold SD electrodes may be provided with a SAM comprising a thiol binding group and a group for improving the contact which may be a group having a high dipole moment; a dopant; or a conjugated moiety.

### OTFT applications

OTFTs according to embodiments of the present invention have a wide range of possible applications. One such application is to drive pixels in an optical device, preferably an organic optical device. Examples of such optical devices include photoresponsive devices, in particular photodetectors, and light-emissive devices, in particular organic light emitting devices. TFTs are particularly suited for use with active matrix organic light emitting devices, e.g. for use in display applications.

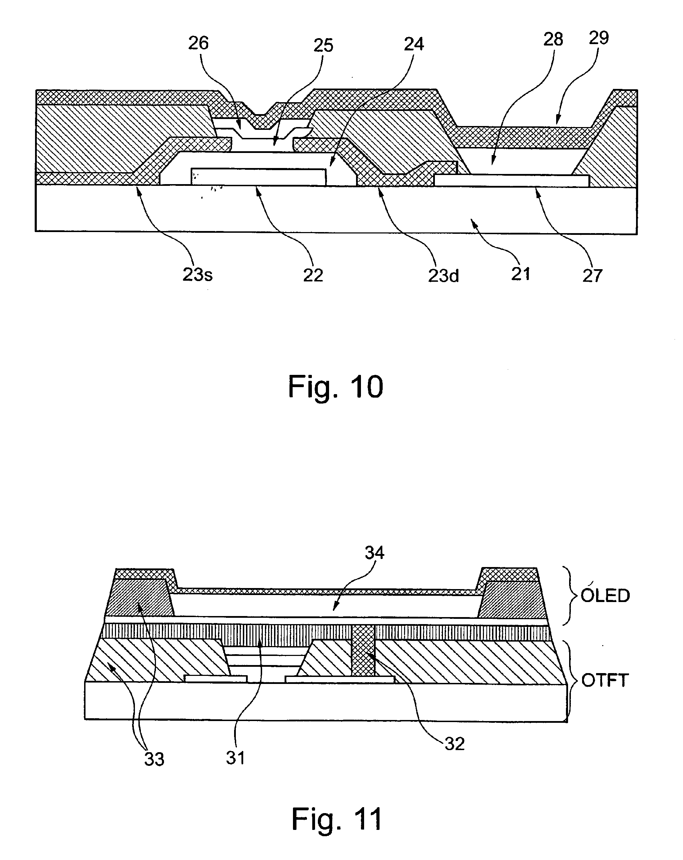

Figure 10 shows a pixel comprising an organic thin film transistor and an adjacent organic light emitting device fabricated on a common substrate 21. The OTFT comprises gate electrode 22, dielectric layer 24, source and drain electrodes 23s and 23d respectively, and OSC layer 25. The OLED comprises anode 27, cathode 29 and an electroluminescent layer 28 provided between the anode and cathode. Further layers may be located between the anode and cathode, such as charge transporting, charge injecting or charge blocking layers. In the embodiment of Figure 10, the layer of cathode material extends across both the OTFT and the OLED, and an insulating layer 26 is provided to electrically isolate the cathode layer 29 from the OSC layer 25. In this embodiment, the drain electrode 23d is directly connected to the anode of the organic light emitting device for switching the organic light emitting device between emitting and non-emitting states.

The active areas of the OTFT and the OLED are defined by a common bank material formed by depositing a layer of photoresist on substrate 21 and patterning it to define OTFT and OLED areas on the substrate. In accordance with an embodiment of the present invention the common bank has a well-defining structure as described previously.

In an alternative arrangement illustrated in Figure 11, an organic thin film transistor may be fabricated in a stacked relationship to an organic light emitting device. In such an embodiment, the organic thin film transistor is built up as described above in either a top or bottom gate configuration. As with the embodiment of Figure 10, the active areas of the OTFT and OLED are defined by a patterned layer of photoresist 33, however in this stacked arrangement, there are two separate bank structures 33 - one for the OLED and one for the OTFT. In accordance with an embodiment of the present invention these two separate bank structures each have a well-defining structure as described previously.

A planarisation layer 31 (also known as a passivation layer) is deposited over the OTFT. Exemplary passivation layers include BCBs and parylenes. An organic light emitting device is fabricated over the passivation layer. The anode 34 of the organic light emitting device is electrically connected to the drain electrode of the organic thin film transistor by a conductive via 32 passing through passivation layer 31 and bank layer 33.

It will be appreciated that pixel circuits comprising an OTFT and an optically active area (e.g. light emitting or light sensing area) may comprise further elements. In particular, the OLED pixel circuits of Figures 10 and 11 will typically comprise least one further transistor in addition to the driving transistor shown, and at least one capacitor.

It will be appreciated that the organic light emitting devices described herein may be top or bottom-emitting devices. That is, the devices may emit light through either the anode or cathode side of the device. In a transparent device, both the anode and cathode are transparent. It will be appreciated that a transparent cathode device need not have a transparent anode (unless, of course, a fully transparent device is desired), and so the transparent anode used for bottom-emitting devices may be replaced or supplemented with a layer of reflective material such as a layer of aluminium.

Transparent cathodes are particularly advantageous for active matrix devices because emission through a transparent anode in such devices may be at least partially blocked by OTFT drive circuitry located underneath the emissive pixels as can be seen from the embodiment illustrated in Figure 11.

Materials and processes suitable for forming an OLED in accordance with embodiments of the present invention are discussed in further detail below.

### General device architecture

The architecture of an electroluminescent device according to an embodiment of the invention comprises a transparent glass or plastic substrate, an anode and a cathode. An electroluminescent layer is provided between anode and cathode.

In a practical device, at least one of the electrodes is semi-transparent in order that light may be absorbed (in the case of a photoresponsive device) or emitted (in the case of an OLED). Where the anode is transparent, it typically comprises indium tin oxide.

### Charge transport layers

Further layers may be located between anode and cathode, such as charge transporting, charge injecting or charge blocking layers.

In particular, it is desirable to provide a conductive hole injection layer, which may be formed from a conductive organic or inorganic material provided between the anode and the electroluminescent layer to assist hole injection from the anode into the layer or layers of semiconducting polymer. Examples of doped organic hole injection materials include doped poly(ethylene dioxythiophene) (PEDT), in particular PEDT doped with a charge-balancing polyacid such as polystyrene sulfonate (PSS) as disclosed in EP 0901176 and EP 0947123, polyacrylic acid or a fluorinated sulfonic acid, for example Nafion ®; polyaniline as disclosed in US 5723873 and US 5798170; and poly(thienothiophene). Examples of conductive inorganic materials include transition metal oxides such as VOx MoOx and RuOx as disclosed in Journal of Physics D: Applied Physics (1996), 29(11), 2750-2753.

If present, a hole transporting layer located between anode and electroluminescent layer preferably has a HOMO level of less than or equal to 5.5 eV, more preferably around 4.8-5.5 eV. HOMO levels may be measured by cyclic voltammetry, for example.

If present, an electron transporting layer located between electroluminescent layer 3 and cathode 4 preferably has a LUMO level of around 3-3.5 eV.

### Electroluminescent layer

The electroluminescent layer may consist of the electroluminescent material alone or may comprise the electroluminescent material in combination with one or more further materials. In particular, the electroluminescent material may be blended with hole and / or electron transporting materials as disclosed in, for example, WO 99/48160, or may comprise a luminescent dopant in a semiconducting host matrix. Alternatively, the electroluminescent material may be covalently bound to a charge transporting material and / or host material.

The electroluminescent layer may be patterned or unpatterned. A device comprising an unpatterned layer may be used an illumination source, for example. A white light emitting device is particularly suitable for this purpose. A device comprising a patterned layer may be, for example, an active matrix display or a passive matrix display. In the case of an active matrix display, a patterned electroluminescent layer is typically used in combination with a patterned anode layer and an unpatterned cathode. In the case of a passive matrix display, the anode layer is formed of parallel stripes of anode material, and parallel stripes of electroluminescent material and cathode material arranged perpendicular to the anode material wherein the stripes of electroluminescent material and cathode material are typically separated by stripes of insulating material ("cathode separators") formed by photolithography.

Suitable materials for use in electroluminescent layer include small molecule, polymeric and dendrimeric materials, and compositions thereof. Suitable electroluminescent polymers include poly(arylene vinylenes) such as poly(p-phenylene vinylenes) and polyarylenes such as: polyfluorenes, particularly 2,7-linked 9,9 dialkyl polyfluorenes or 2,7-linked 9,9 diaryl polyfluorenes; polyspirofluorenes, particularly 2,7-linked poly-9,9-spirofluorene; polyindenofluorenes, particularly 2,7-linked polyindenofluorenes; polyphenylenes, particularly alkyl or alkoxy substituted poly-1,4-phenylene. Such polymers as disclosed in, for example, Adv. Mater. 2000 12(23) 1737-1750 and references therein. Suitable electroluminescent dendrimers include electroluminescent metal complexes bearing dendrimeric groups as disclosed in, for example, WO 02/066552.

### Cathode

The cathode is selected from materials that have a workfunction allowing injection of electrons into the electroluminescent layer. Other factors influence the selection of the cathode such as the possibility of adverse interactions between the cathode and the electroluminescent material. The cathode may consist of a single material such as a layer of aluminium. Alternatively, it may comprise a plurality of metals, for example a bilayer of a low workfunction material and a high workfunction material such as calcium and aluminium as disclosed in WO 98/10621; elemental barium as disclosed in WO 98/57381, Appl. Phys. Lett. 2002, 81(4), 634 and WO 02/84759; or a thin layer of metal compound, in particular an oxide or fluoride of an alkali or alkali earth metal, to assist electron injection, for example lithium fluoride as disclosed in WO 00/48258; barium fluoride as disclosed in Appl. Phys. Lett. 2001, 79(5), 2001; and barium oxide. In order to provide efficient injection of electrons into the device, the cathode preferably has a workfunction of less than 3.5 eV, more preferably less than 3.2 eV, most preferably less than 3 eV. Work functions of metals can be found in, for example, Michaelson, J. Appl. Phys. 48(11), 4729, 1977. The cathode may be opaque or transparent. Transparent cathodes are particularly advantageous for active matrix devices because emission through a transparent anode in such devices is at least partially blocked by drive circuitry located underneath the emissive pixels. A transparent cathode will comprise a layer of an electron injecting material that is sufficiently thin to be transparent. Typically, the lateral conductivity of this layer will be low as a result of its thinness. In this case, the layer of electron injecting material is used in combination with a thicker layer of transparent conducting material such as indium tin oxide.

It will be appreciated that a transparent cathode device need not have a transparent anode (unless, of course, a fully transparent device is desired), and so the transparent anode used for bottom-emitting devices may be replaced or supplemented with a layer of reflective material such as a layer of aluminium. Examples of transparent cathode devices are disclosed in, for example, GB 2348316.

### Encapsulation

Optical devices tend to be sensitive to moisture and oxygen. Accordingly, the substrate preferably has good barrier properties for prevention of ingress of moisture and oxygen into the device. The substrate is commonly glass. However, alternative substrates may be used, in particular where flexibility of the device is desirable. For example, the substrate may comprise a plastic as in US 6268695 which discloses a substrate of alternating plastic and barrier layers or a laminate of thin glass and plastic as disclosed in EP 0949850.

The device is preferably encapsulated with an encapsulant to prevent ingress of moisture and oxygen. Suitable encapsulants include a sheet of glass, films having suitable barrier properties such as alternating stacks of polymer and dielectric as disclosed in, for example, WO 01/81649 or an airtight container as disclosed in, for example, WO 01/19142. A getter material for absorption of any atmospheric moisture and / or oxygen that may permeate through the substrate or encapsulant may be disposed between the substrate and the encapsulant.

### Solution processing

A single polymer or a plurality of polymers may be deposited from solution. Suitable solvents for polyarylenes, in particular polyfluorenes, include mono- or poly-alkylbenzenes such as toluene and xylene. Particularly preferred solution deposition techniques are spin-coating and inkjet printing.

Spin-coating is particularly suitable for devices wherein patterning of the electroluminescent material is unnecessary - for example for lighting applications or simple monochrome segmented displays.

Inkjet printing is particularly suitable for high information content displays, in particular full colour displays. Inkjet printing of OLEDs is described in, for example, EP 0880303.

Other solution deposition techniques include dip-coating, roll printing and screen printing.

If multiple layers of the device are formed by solution processing then the skilled person will be aware of techniques to prevent intermixing of adjacent layers, for example by crosslinking of one layer before deposition of a subsequent layer or selection of materials for adjacent layers such that the material from which the first of these layers is formed is not soluble in the solvent used to deposit the second layer.

### Hosts for phosphorescent emitters

Numerous hosts are described in the prior art including "small molecule" hosts such as 4,4'-bis(carbazol-9-yl)biphenyl), known as CBP, and (4,4',4"-tris(carbazol-9-yl)triphenylamine), known as TCTA, disclosed in Ikai et al., Appl. Phys. Lett., 79 no. 2, 2001, 156; and triarylamines such as tris-4-(N-3-methylphenyl-N-phenyl)phenylamine, known as MTDATA. Polymers are also known as hosts, in particular homopolymers such as poly(vinyl carbazole) disclosed in, for example, Appl. Phys. Lett. 2000, 77(15), 2280; polyfluorenes in Synth. Met. 2001, 116, 379, Phys. Rev. B 2001, 63, 235206 and Appl. Phys. Lett. 2003, 82(7), 1006; poly[4-(N-4-vinylbenzyloxyethyl, N-methylamino)-N-(2,5-di-tert-butylphenylnapthalimide] in Adv. Mater. 1999, 11(4), 285; and poly(para-phenylenes) in J. Mater. Chem. 2003, 13, 50-55. Copolymers are also known as hosts.

### Metal complexes (mostly phosphorescent but includes fluorescent at the end)

Preferred metal complexes comprise optionally substituted complexes of formula:

ML¹_{q}L²ᵣL³ₛ

wherein M is a metal; each of L¹, L² and L³ is a coordinating group; q is an integer; r and s are each independently 0 or an integer; and the sum of (a. q) + (b. r) + (c.s) is equal to the number of coordination sites available on M, wherein a is the number of coordination sites on L¹, b is the number of coordination sites on L² and c is the number of coordination sites on L³.

Heavy elements M induce strong spin-orbit coupling to allow rapid intersystem crossing and emission from triplet or higher states (phosphorescence). Suitable heavy metals M include:
- lanthanide metals such as cerium, samarium, europium, terbium, dysprosium, thulium, erbium and neodymium; and
- d-block metals, in particular those in rows 2 and 3 i.e. elements 39 to 48 and 72 to 80, in particular ruthenium, rhodium, pallaidum, rhenium, osmium, iridium, platinum and gold.

Suitable coordinating groups for the f-block metals include oxygen or nitrogen donor systems such as carboxylic acids, 1,3-diketonates, hydroxy carboxylic acids, Schiff bases including acyl phenols and iminoacyl groups. As is known, luminescent lanthanide metal complexes require sensitizing group(s) which have the triplet excited energy level higher than the first excited state of the metal ion. Emission is from an f-f transition of the metal and so the emission colour is determined by the choice of the metal. The sharp emission is generally narrow, resulting in a pure colour emission useful for display applications.

The d-block metals are particularly suitable for emission from triplet excited states. These metals form organometallic complexes with carbon or nitrogen donors such as porphyrin or bidentate ligands of formula: 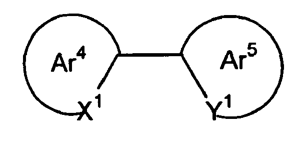 wherein Ar⁴ and Ar⁵ may be the same or different and are independently selected from optionally substituted aryl or heteroaryl; X¹ and Y¹ may be the same or different and are independently selected from carbon or nitrogen; and Ar⁴ and Ar⁵ may be fused together. Ligands wherein X¹ is carbon and Y¹ is nitrogen are particularly preferred.

Examples of bidentate ligands are illustrated below:

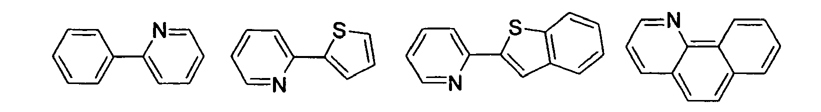

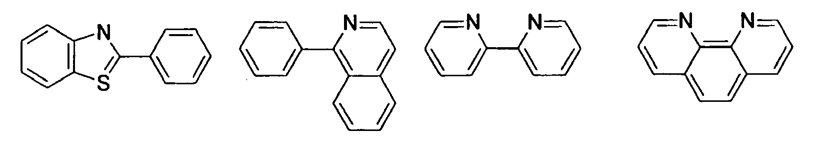

Each of Ar⁴ and Ar⁵ may carry one or more substituents. Two or more of these substituents may be linked to form a ring, for example an aromatic ring. Particularly preferred substituents include fluorine or trifluoromethyl which may be used to blue-shift the emission of the complex as disclosed in WO 02/45466, WO 02/44189, US 2002-117662 and US 2002-182441; alkyl or alkoxy groups as disclosed in JP 2002-324679; carbazole which may be used to assist hole transport to the complex when used as an emissive material as disclosed in WO 02/81448; bromine, chlorine or iodine which can serve to functionalise the ligand for attachment of further groups as disclosed in WO 02/68435 and EP 1245659; and dendrons which may be used to obtain or enhance solution processability of the metal complex as disclosed in WO 02/66552.

A light-emitting dendrimer typically comprises a light-emitting core bound to one or more dendrons, wherein each dendron comprises a branching point and two or more dendritic branches. Preferably, the dendron is at least partially conjugated, and at least one of the core and dendritic branches comprises an aryl or heteroaryl group. In one preferred embodiment, the branch group comprises

Other ligands suitable for use with d-block elements include diketonates, in particular acetylacetonate (acac); triarylphosphines and pyridine, each of which may be substituted.

Main group metal complexes show ligand based, or charge transfer emission. For these complexes, the emission colour is determined by the choice of ligand as well as the metal.

The host material and metal complex may be combined in the form of a physical blend. Alternatively, the metal complex may be chemically bound to the host material. In the case of a polymeric host, the metal complex may be chemically bound as a substituent attached to the polymer backbone, incorporated as a repeat unit in the polymer backbone or provided as an endgroup of the polymer as disclosed in, for example, EP 1245659, WO 02/31896, WO 03/18653 and WO 03/22908.

A wide range of fluorescent low molecular weight metal complexes are known and have been demonstrated in organic light emitting devices [see, e. g., Macromol. Sym. 125 (1997) 1-48, US-A 5,150,006, US-A 6,083,634 and US-A 5,432,014]. Suitable ligands for di or trivalent metals include: oxinoids, e. g. with oxygen-nitrogen or oxygen-oxygen donating atoms, generally a ring nitrogen atom with a substituent oxygen atom, or a substituent nitrogen atom or oxygen atom with a substituent oxygen atom such as 8-hydroxyquinolate and hydroxyquinoxalinol-10-hydroxybenzo (h) quinolinato (II), benzazoles (III), schiff bases, azoindoles, chromone derivatives, 3-hydroxyflavone, and carboxylic acids such as salicylato amino carboxylates and ester carboxylates. Optional substituents include halogen, alkyl, alkoxy, haloalkyl, cyano, amino, amido, sulfonyl, carbonyl, aryl or heteroaryl on the (hetero) aromatic rings which may modify the emission colour.

While this invention has been particularly shown and described with reference to preferred embodiments thereof, it will be understood by those skilled in the art that various changes in form and detail may be made therein without departing from the scope of the invention as defined by the appended claims.

## Claims

1. A method of manufacturing an organic electronic device, the method comprising:
providing a substrate; forming a well-defining structure over the substrate; and depositing a solution of organic semiconductive material and/or organic conductive material in wells defined by the well-defining structure, wherein the well-defining structure is formed by depositing a solution comprising a mixture of a first insulating material and a second insulating material, the second insulating material having a lower wettability than the first insulating material, and allowing the first and second insulating materials to at least partially phase separate wherein the second insulating material phase separates in a direction away from the substrate.

2. A method according to claim 1, wherein the first and second insulating materials completely phase separate in order to form two distinct and separate layers.

3. A method according to claim 1, wherein the first and second insulating materials partially phase separate such that at least a portion of the well-defining structure comprises a mixture of the first and second materials.

4. A method according to claim 3, wherein the first and second insulating materials partially phase separate to form three zones: a lower zone comprising substantially no second insulating material adjacent the substrate; an upper zone comprising substantially no first insulating material on an opposite side to the substrate; and an intermediate zone comprising a mixture of the first and second insulating material.

5. A method according to any preceding claim, wherein the wells are formed after allowing the first and second insulating materials to at least partially phase separate.

6. A method according to any preceding claim, wherein a baking step is performed after depositing the solution comprising the first and insulating materials to encourage the first and second materials to phase separate.

7. A method according to any preceding claim, wherein the contact angle of the first material with water is less than 60°, preferably less than 50 °, more preferably less than 40° and most preferably less than 30 °.

8. A method according to any preceding claim, wherein the contact angle of the second material with water is greater than 60 °, preferably greater than 70 °, more preferably greater than 80 ° and most preferably greater than 90 °.

9. A method according to any preceding claim, wherein the difference between the contact angles of the first and second materials with water is at least 20 °.

10. A method according to any preceding claim, wherein the first insulating material is a polymer resist material.

11. A method according to any preceding claim, wherein the second insulating material is a fluorinated polymer.

12. A method according to claim 11, wherein the fluorinated polymer comprises solubilising groups.

13. A method according to any preceding claim, wherein the well-defining structure comprises 20% by weight or less of the second insulating material.

14. An organic electronic device comprising: a substrate; a well-defining structure disposed over the substrate; and organic semiconductive and/or organic conductive material disposed in wells defined by the well-defining structure, wherein the well-defining structure comprises a first insulating material and a second insulating material, the second insulating material having a lower wettability than the first insulating material, wherein the second insulating material has a concentration which increases in a direction away from the substrate and at least a portion of the well-defining structure comprises a mixture of the first and second materials.

15. An organic electronic device according to claim 14, wherein the well-defining structure comprises three zones: a lower zone comprising substantially no second insulating material adjacent the substrate; an upper zone comprising substantially no first insulating material on an opposite side to the substrate; and an intermediate zone comprising a mixture of the first and second insulating material.

## Patentansprüche

1. Verfahren zum Herstellen eines organischen elektronischen Bauelements, wobei das Verfahren Folgendes umfasst: Bereitstellen eines Substrats; Ausbilden einer wohldefinierten Struktur über dem Substrat; und Abscheiden einer Lösung aus organischem halbleitenden Material und/oder organischem leitenden Material in durch die wohldefinierte Struktur definierten Mulden, wobei die wohldefinierte Struktur ausgebildet wird durch Abscheiden einer Lösung, die eine Mischung aus einem ersten Isoliermaterial und einem zweiten Isoliermaterial umfasst, wobei das zweite Isoliermaterial eine geringere Benetzbarkeit als das erste Isoliermaterial aufweist, und Gestatten dem ersten und zweiten Isoliermaterial eine mindestens teilweisen Phasentrennung, wobei sich das zweite Isoliermaterial in seiner Phase in einer Richtung weg von dem Substrat trennt.

2. Verfahren nach Anspruch 1, wobei das erste und zweite Isoliermaterial eine vollständige Phasentrennung erfahren, um zwei verschiedene und getrennte Schichten auszubilden.

3. Verfahren nach Anspruch 1, wobei das erste und zweite Isoliermaterial eine teilweise Phasentrennung erfahren, so dass mindestens ein Abschnitt der wohldefinierten Struktur eine Mischung aus dem ersten und zweiten Material umfasst.

4. Verfahren nach Anspruch 3, wobei das erste und zweite Isoliermaterial eine teilweise Phasentrennung erfahren, um drei Zonen auszubilden: eine untere Zone, die im Wesentlichen kein zweites Isoliermaterial bei dem Substrat umfasst; eine obere Zone, die im Wesentlichen kein erstes Isoliermaterial auf einer gegenüberliegenden Seite zu dem Substrat umfasst; und eine Zwischenzone, die eine Mischung aus dem ersten und zweiten Isoliermaterial umfasst.

5. Verfahren nach einem vorhergehenden Anspruch, wobei die Mulden ausgebildet werden, nachdem dem ersten und zweiten Isoliermaterial gestattet wurde, mindestens teilweise eine Phasentrennung zu erfahren.

6. Verfahren nach einem vorhergehenden Anspruch, wobei ein Aushärtungsschritt nach dem Abscheiden der Lösung umfassend das erste und zweite Isoliermaterial durchgeführt wird, um eine Phasentrennung des ersten und zweiten Materials zu anzuregen.

7. Verfahren nach einem vorhergehenden Anspruch, wobei der Kontaktwinkel des ersten Materials mit Wasser unter 60° liegt, bevorzugt unter 50°, besonders bevorzugt unter 40° und ganz besonders bevorzugt unter 30°.

8. Verfahren nach einem vorhergehenden Anspruch, wobei der Kontaktwinkel des zweiten Materials mit Wasser über 60° liegt, bevorzugt über 70°, besonders bevorzugt über 80° und ganz besonders bevorzugt über 90°.

9. Verfahren nach einem vorhergehenden Anspruch, wobei die Differenz zwischen den Kontaktwinkeln des ersten und zweiten Materials mit Wasser mindestens 20° beträgt.

10. Verfahren nach einem vorhergehenden Anspruch, wobei das erste Isoliermaterial ein Polymerresist-material ist.

11. Verfahren nach einem vorhergehenden Anspruch, wobei das zweite Isoliermaterial ein fluoriertes Polymer ist.

12. Verfahren nach Anspruch 11, wobei das fluorierte Polymer löslich machende Gruppen umfasst.

13. Verfahren nach einem vorhergehenden Anspruch, wobei die wohldefinierte Struktur 20 Gew.-% oder weniger des zweiten Isoliermaterials umfasst.

14. Organisches elektronisches Bauelement, das Folgendes umfasst: ein Substrat; eine über dem Substrat angeordnete wohldefinierte Struktur; und organisch halbleitendes und/oder organisch leitendes Material, das in Mulden angeordnet ist, die durch die wohldefinierte Struktur definiert sind, wobei die wohldefinierte Struktur ein erstes Isoliermaterial und ein zweites Isoliermaterial umfasst, wobei das zweite Isoliermaterial eine geringere Benetzbarkeit als das erste Isoliermaterial aufweist, wobei das zweite Isoliermaterial eine Konzentration aufweist, die in einer Richtung weg von dem Substrat zunimmt, und mindestens ein Teil der wohldefinierten Struktur eine Mischung aus dem ersten und zweiten Material umfasst.

15. Organisches elektronisches Bauelement nach Anspruch 14, wobei die wohldefinierte Struktur drei Zonen umfasst: eine untere Zone, die im Wesentlichen kein zweites Isoliermaterial bei dem Substrat umfasst; eine obere Zone, die im Wesentlichen kein erstes Isoliermaterial auf einer gegenüberliegenden Seite zu dem Substrat umfasst; und eine Zwischenzone, die eine Mischung aus dem ersten und zweiten Isoliermaterial umfasst.

## Revendications

1. Procédé de fabrication d'un dispositif électronique organique, le procédé comprenant les étapes consistant à :
utiliser un substrat ; former une structure de définition de puits sur le substrat ; et déposer une solution de matériau semi-conducteur organique et/ou un matériau conducteur organique dans des puits définis par la structure de définition de puits, la structure de définition de puits étant formée en déposant une solution comprenant un mélange d'un premier matériau isolant et d'un second matériau isolant, le second matériau isolant ayant une mouillabilité inférieure à celle du premier matériau isolant, et en laissant les premier et second matériaux isolants se séparer au moins partiellement en phases, la phase du second matériau isolant se séparant dans une direction s'écartant du substrat.

2. Procédé selon la revendication 1, dans lequel les premier et second matériaux isolants se séparent complètement en phases de manière à former deux couches distinctes et séparées.

3. Procédé selon la revendication 1, dans lequel les premier et second matériaux isolants se séparent partiellement en phases de telle manière qu'au moins une partie de la structure de définition de puits comprend un mélange des premier et second matériaux.

4. Procédé selon la revendication 3, dans lequel les premier et second matériaux isolants se séparent partiellement en phases pour former trois zones : une zone inférieure ne comprenant sensiblement aucun second matériau isolant adjacent au substrat ; une zone supérieure ne comprenant sensiblement aucun premier matériau isolant sur une face opposée au substrat ; et une zone intermédiaire comprenant un mélange des premier et second matériaux isolants.

5. Procédé selon l'une quelconque des revendications précédentes, dans lequel les puits sont formés après avoir laissé les premier et second matériaux isolants se séparer au moins partiellement en phases.

6. Procédé selon l'une quelconque des revendications précédentes, dans lequel une étape de cuisson est exécutée après avoir déposé la solution comprenant les premier et second matériaux isolants pour favoriser leur séparation en phases.

7. Procédé selon l'une quelconque des revendications précédentes, dans lequel l'angle de contact du premier matériau avec l'eau est inférieur à 60°, de préférence inférieur à 50°, de préférence encore inférieur à 40° et idéalement inférieur à 30°.

8. Procédé selon l'une quelconque des revendications précédentes, dans lequel l'angle de contact du second matériau avec l'eau est supérieur à 60°, de préférence supérieur à 70°, de préférence encore supérieur à 80° et idéalement supérieur à 90°.

9. Procédé selon l'une quelconque des revendications précédentes, dans lequel la différence entre les angles de contact des premier et second matériaux avec l'eau est au moins de 20°.

10. Procédé selon l'une quelconque des revendications précédentes, dans lequel le premier matériau isolant est un matériau résist polymère.

11. Procédé selon l'une quelconque des revendications précédentes, dans lequel le second matériau isolant est un matériau polymère fluoré.

12. Procédé selon la revendication 11, dans lequel le matériau fluoré comprend des groupes de solubilisation.

13. Procédé selon l'une quelconque des revendications précédentes, dans lequel la structure de définition de puits comprend 20 % en masse, ou moins, du second matériau isolant.

14. Dispositif électronique organique comprenant : un substrat ; une structure de définition de puits disposée sur le substrat ; et un matériau semi-conducteur organique et/ou un matériau conducteur organique disposé dans des puits définis par la structure de définition de puits, la structure de définition de puits comprenant un premier matériau isolant et un second matériau isolant, le second matériau isolant ayant une mouillabilité inférieure à celle du premier matériau isolant, le second matériau isolant ayant une concentration qui augmente dans une direction s'écartant du substrat et au moins une partie de la structure de définition de puits comprenant un mélange des premier et second matériaux.

15. Dispositif électronique organique selon la revendication 14, dans lequel la structure de définition de puits comprend trois zones : une zone inférieure ne comprenant sensiblement aucun second matériau isolant adjacent au substrat ; une zone supérieure ne comprenant sensiblement aucun premier matériau isolant sur une face opposée au substrat ; et une zone intermédiaire comprenant un mélange des premier et second matériaux isolants.
